Europäisches Patentamt

European Patent Office

Office européen des brevets

(11) Numéro de publication : **0 442 797 A1**

# (12) DEMANDE DE BREVET EUROPEEN

(21) Numéro de dépôt : **91400337.1**

(22) Date de dépôt : **12.02.91**

(51) Int. Cl.⁵ : **H01P 1/10, H03F 3/60**

(30) Priorité : **16.02.90 FR 9001878**

(43) Date de publication de la demande :
**21.08.91 Bulletin 91/34**

(84) Etats contractants désignés :
**BE CH DE FR GB IT LI NL SE**

(71) Demandeur : **THOMSON TUBES ELECTRONIQUES**
**38, rue Vauthier**
**F-92100 Boulogne-Billancourt (FR)**

(72) Inventeur : **Firmain, Gérard**
**THOMSON-CSF, SCPI, Cedex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Circuit de commutation d'un signal de sortie hyperfréquence vers une première ou une deuxième sortie.**

(57)    L'invention concerne un circuit de commutation d'un signal de sortie hyperfréquence vers une première sortie (S) ou une deuxième sortie (S').

Le circuit comporte : deux amplificateurs (A1, A2) recevant en entrée deux parties sensiblement égales en puissance d'un signal d'entrée, un coupleur (H) ayant deux entrées (E,E') connectées aux sorties des amplificateurs (A1,A2) et deux sorties (S,S') réalisant les sorties du circuit de commutation, des moyens de déphasage (PH) commandables pour mettre en phase ou en opposition de phase, les signaux injectés en entrée des amplificateurs (A1,A2) et pour obtenir le signal de sortie tantôt sur une sortie (S) du coupleur (H) tantôt sur l'autre (S').

Applications : Circuits de commutation d'antennes.

FIG.2

EP 0 442 797 A1

# CIRCUIT DE COMMUTATION D'UN SIGNAL DE SORTIE HYPERFREQUENCE VERS UNE PREMIERE OU UNE DEUXIEME SORTIE

La présente invention concerne un circuit de commutation d'un signal hyperfréquence vers une première ou une deuxième sortie. Ce signal est de préférence un signal de puissance. Elle concerne aussi un dispositif de commutation comprenant plusieurs circuits de commutation.

Ce circuit de commutation et ce dispositif de commutation sont destinés notamment à commuter l'alimentation d'antennes. Ils permettent l'envoi d'un signal délivré par l'étage final de puissance d'un émetteur vers une antenne choisie parmi plusieurs.

Dans certaines applications il est nécessaire qu'un signal de puissance, issu d'un étage final d'un émetteur soit orienté vers une utilisation particulière, par exemple un aérien illuminant une zone de réception particulière. Les satellites de télécommunications peuvent comporter des aériens illuminant successivement des zones distinctes. Un signal réamplifié dans un transpondeur doit être orienté vers l'aérien correspondant à la zone à illuminer, en fonction du trafic à acheminer.

Dans certains systèmes radar, un signal sortant d'un émetteur doit être envoyé tantôt vers un aérien dit principal, tantôt vers un aérien dit de contrôle.

Dans les circuits de commutation existants, la commutation est réalisée en sortie de l'étage final de puissance de l'émetteur grâce à un commutateur.

Ce commutateur peut être mécanique, électromécanique ou à ferrite. Il peut être commandé manuellement ou à distance. Dans tous les cas il doit commuter des signaux à puissance crête élevée, jusqu'à plusieurs kilowatts, et à puissance moyenne allant de plusieurs dizaines à plusieurs centaines de watts.

Ces circuits de commutation classiques présentent plusieurs inconvénients.

A forte puissance, les pertes de transmission dans le commutateur peuvent atteindre des niveaux de l'ordre du décibel. Pour qu'un aérien rayonne une puissance donnée, il faut que l'étage final de l'émetteur fournisse environ 25 % de puissance en plus de celle rayonnée par l'aérien. Les pertes de transmission dans le commutateur nécessitent l'emploi d'un dispositif de refroidissement particulier.

La fiabilité des commutateurs de puissance décroît d'une part, avec le niveau de puissance en jeu et d'autre part, avec le nombre de commutations par unité de temps.

En cas de défaillance de l'étage de puissance de l'émetteur, pour ne pas interrompre l'émission, une solution classique consiste à utiliser deux chaînes d'amplification identiques. Une seule est en service, l'autre est passive, en redondance. On doit utiliser un commutateur supplémentaire pour rendre active, en cas de besoin, la chaîne d'amplification passive. Le commutateur supplémentaire double les pertes de transmission. Les chaînes d'amplification doivent fournir chacune environ 60 % de puissance supplémentaire par rapport à la puissance rayonnée par l'aérien, si l'on considère que chaque commutateur à des pertes de 1 décibel.

Dans les systèmes de télécommunications par satellite, les niveaux de puissance émis par le transpondeur embarqué ne dépassent pas, actuellement, les 300 W continus. Mais les pertes des commutateurs et leur fiabilité réduite limitent de façon importante les performances de tels systèmes.

Au sol les puissances émises sont très variables et peuvent aller de quelques watts à quelques mégawatts.

La présente invention vise à remédier à ces inconvénients. Elle propose un circuit de commutation comprenant deux chaînes d'amplification, alimentées avec des parties sensiblement égales en puissance d'un signal d'entrée. Les sorties des chaînes d'amplification sont combinées dans un coupleur à faibles pertes. Des moyens de déphasage commandables établissent, en entrée du coupleur, des signaux en phase ou en opposition de phase de manière à obtenir la somme des signaux de sortie des chaînes d'amplification, soit sur une sortie du coupleur soit sur l'autre.

Elle propose aussi un dispositif de commutation comportant $2^n$ circuits de commutation.

Le circuit de commutation selon l'invention est destiné à commuter un signal de sortie vers une première ou une deuxième sortie. Il comporte un coupleur avec deux entrées et deux sorties qui réalisent les sorties du circuit.

Deux amplificateurs reçoivent en entrée, deux parties sensiblement égales en puissance d'un signal d'entrée à amplifier et alimentent chacun une entrée du coupleur.

Des moyens de déphasage commandables, disposés en amont d'au moins un des amplificateurs, mettent en phase ou en opposition de phase, les signaux présents en entrée du coupleur afin d'obtenir le signal de sortie tantôt sur une sortie du coupleur, tantôt sur l'autre.

De préférence, un coupleur diviseur est alimenté avec le signal d'entrée et fournit sur deux sorties, les parties sensiblement égales en puissance du signal d'entrée.

De préférence les amplificateurs sont sensiblement identiques et le coupleur est un coupleur dit "180°".

Les moyens de déphasage commandables sont réalisés par au moins un déphaseur variable commandable inséré entre une sortie du coupleur diviseur et l'entrée de l'amplificateur correspondant.

On peut prévoir, à l'entrée des amplificateurs, un dispositif d'égalisation des longueurs électriques entre l'entrée et la sortie des amplificateurs.

On peut aussi prévoir, à l'entrée des amplificateurs, un dispositif d'égalisation des amplitudes des signaux de sortie des amplificateurs.

Un circuit d'asservissement recevant au moins un signal de sortie du coupleur, peut commander les dispositifs d'égalisation.

Un dispositif d'utilisation est connecté à chaque sortie du circuit de commutation.

Un filtre de bande peut être inséré entre chaque sortie du circuit de commutation et chaque dispositif d'utilisation, ces filtres pouvant être centrés sur des fréquences différentes, le circuit de commutation pouvant commuter des signaux à des fréquences différentes.

L'invention propose aussi un dispositif de commutation d'un signal de sortie vers une sortie prise parmi $2^{n+1}$, comportant $2^n$ circuits de commutation tels que décrits précédemment. Les entrées des $2^n$ circuits de commutation sont alimentées par les sorties d'une cascade de n étages de coupleurs diviseurs et moyens de déphasage commandables.

Les sorties des $2^n$ circuits de commutation sont reliées aux entrées d'une cascade de n étages de $2^{n+1}$ coupleurs avec $2^n$ coupleurs dans chaque étage.

Chaque étage de rang i de coupleurs diviseurs et moyens de déphasage comprend $2^{i-1}$ coupleurs diviseurs et $2^{i-1}$ moyens de déphasage commandables tous simultanément pour l'étage considéré, pour établir en sortie de chaque coupleur diviseur/moyens de déphasage, des signaux soit en phase, soit en opposition de phase, destinés à être appliqués aux entrées des coupleurs diviseurs de l'étage de rang i+1.

Les entrées des coupleurs d'un étage de rang i sont reliées chacune à une sortie d'un coupleur différent de l'étage de rang i-1.

Au plus $2^{n+1}$ circuits utilisateurs sont connectés aux sorties des $2^n$ coupleurs de l'étage de rang n. Une charge adaptée est connectée aux sorties des $2^n$ coupleurs de l'étage de rang n non reliées à un circuit utilisateur.

D'autres caractéristiques et avantages de l'invention apparaîtront à la lecture de la description suivante, donnée à titre non limitatif, illustrée des figures jointes parmi lesquelles :

– la figure 1 représente un circuit de commutation à deux sorties selon l'art antérieur ;

– la figure 2 représente un circuit de commutation à deux sorties selon l'invention,

– la figure 3 représente une variante du même circuit de commutation à deux sorties, selon l'invention,

– la figure 4 représente, partiellement, un circuit de commutation à deux sorties fonctionnant en mode dégradé avec un amplificateur redondant ;

– la figure 5 représente un dispositif de commutation à quatre sorties selon l'invention ;

– la figure 6 représente un dispositif de commutation à huit sorties selon l'invention.

Sur ces figures, les mêmes éléments portent les mêmes références.

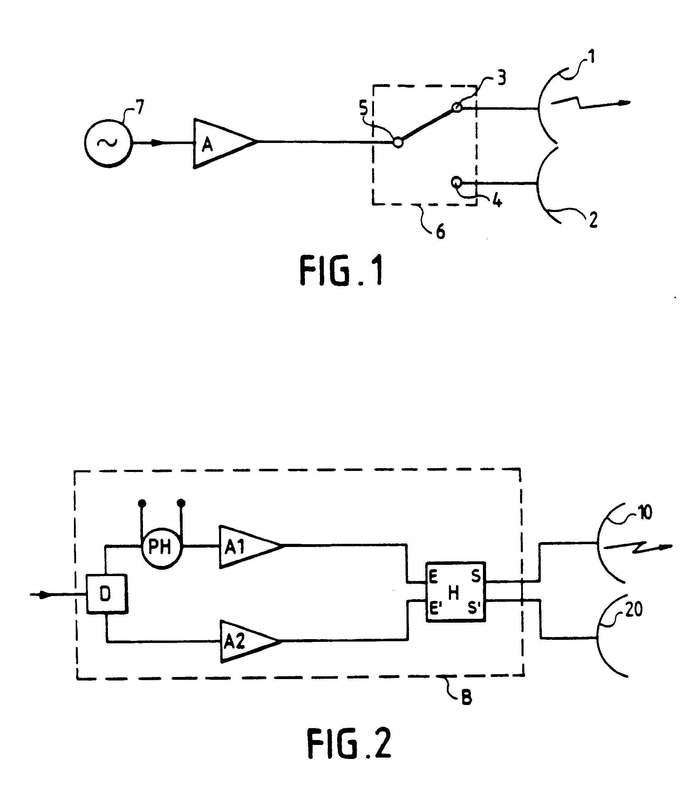

Le circuit représenté sur la figure 1 est utilisé pour la commutation de deux antennes 1,2. Il comporte un pilote 7 qui fournit un signal à amplifier. La sortie du pilote 7 est connectée à l'entrée d'un amplificateur A. La sortie de l'amplificateur A est connectée à l'entrée 5 d'un commutateur 6. Ce commutateur 6 a deux sorties 3,4 respectivement connectées aux antennes 1 et 2. Le signal fourni par le pilote va être amplifié dans l'amplificateur A, et selon la position du commutateur 6 va attenter soit l'antenne 1 soit l'antenne 2.

Sur la figure 1, le signal amplifié sort du commutateur 6 par sa sortie 3 et alimente l'antenne 1. L'antenne 2 n'est pas attentée. Le pilote 7 et l'amplificateur A peuvent faire partie de l'étage final d'un émetteur. L'amplificateur A peut être un tube hyperfréquence tel qu'un T.O.P ou un klystron ou un amplificateur à l'état solide. Le commutateur 6 peut être mécanique, électromécanique ou à ferrite. Il peut être commandé manuellement ou à distance.

La figure 2 représente un circuit de commutation B à deux sorties conforme à l'invention. On utilise deux amplificateurs A1, A2. On peut supposer qu'il s'agit de deux amplificateurs sensiblement identiques, des tubes à ondes progressives, par exemple. On pourrait aussi utiliser des amplificateurs à état solide ou des amplificateurs réalisés avec des circuits hybrides.

Ces amplificateurs A1,A2 reçoivent chacun une partie sensiblement égale en puissance d'un signal d'entrée. Ici il s'agit de la moitié en puissance du signal d'entrée. On utilise un coupleur diviseur D fonctionnant de manière bien connue en diviseur de puissance par deux.

Ce coupleur D reçoit sur son entrée le signal hyperfréquence d'entrée et fournit sur ses deux sorties, un signal dont la puissance est la moitié de la puissance d'entrée.

Le signal d'entrée est fourni par un pilote non représenté.

La sortie des amplificateurs A1, A2 est connectée respectivement aux deux entrées E, E' d'un coupleur H. Les deux sorties S, S' du coupleur H forment les deux sorties du circuit de commutation.

Le coupleur H est un coupleur dit "180°". Son fonctionnement est le suivant : si les signaux alimentant les entrées E et E' ont des déphasages quelconques on obtiendra respectivement sur sa sortie somme S, la somme vectorielle et sur sa sortie différence S' la différence vectorielle des signaux présents en entrée.

Si les signaux alimentant les entrées E et E' sont en phase, on obtiendra sur S leur somme et sur S' leur différence, c'est-à-dire sensiblement aucun signal. Si les signaux alimentant les entrées E et E' sont en opposition de phase on obtiendra leur somme sur S', et sensiblement rien sur S.

Le coupleur H pourra être réalisé par un T magique en guide ou bien par un T magique en ligne triplaque sur circuit céramique, par exemple. Ces coupleurs ont des pertes faibles, inférieures en général au dixième de décibel.

Dans la suite, par commodité on désignera par la même référence, à la fois une entrée ou une sortie du coupleur et le signal présent sur cette entrée ou cette sortie.

Le circuit de commutation comporte au moins des moyens de déphasage commandables pour que les signaux appliqués à l'entrée du coupleur soient, soit en phase, soit en opposition de phase.

Sur la figure 2 on a représenté un déphaseur variable PH commandable inséré entre une sortie du coupleur diviseur D et l'entrée de l'amplificateur A1. Ce n'est qu'un exemple. Il aurait pu être disposé à l'entrée de l'amplificateur A2. On aurait pu utiliser deux déphaseurs variables, l'un connecté à l'entrée de l'amplificateur A1 et l'autre à l'entrée de l'amplificateur A2. Les deux déphaseurs seraient commandés simultanément.

Le déphaseur variable PH commandable peut être un déphaseur à ferrite, à diode PIN ou même mécanique, cela dépend du temps de commutation recherché. Il travaille à bas niveau de puissance car il se trouve en amont des amplificateurs.

Ces deux sorties S, S' sont connectées chacune à un dispositif d'utilisation. Sur la figure 2 on a représenté deux antennes 10,20 et le circuit de commutation selon l'invention permet de commuter le signal d'entrée après amplification tantôt sur une antenne 10 tantôt sur l'autre. On pourrait envisager que le circuit de commutation serve à d'autres applications, par exemple, à des fours à microondes ou des sections d'accélérateurs de particules.

Pour que l'antenne 10 soit alimentée, il faut que les signaux E et E' soient en phase. On commande en conséquence le déphaseur variable PH, pour que les signaux d'entrée du coupleur soient en phase. Le coupleur H fournit sur sa sortie S, la somme des signaux de sortie des amplificateurs A1 et A2 et sensiblement rien sur sa sortie S'.

Au contraire, si on désire que l'antenne 20 soit alimentée, il faut que les signaux E et E' soient en opposition de phase. On commande le déphaseur variable PH pour que les signaux d'entrée du coupleur soient en opposition de phase. On obtient sur la sortie S' la somme des signaux E et E' et sensiblement rien sur la sortie S.

Le circuit de commutation selon l'invention permet de combiner dans un coupleur à faibles pertes, des signaux à haut niveau de puissance et la commutation est réalisée par des moyens de déphasage commandables travaillant sur des signaux à bas niveau de puissance.

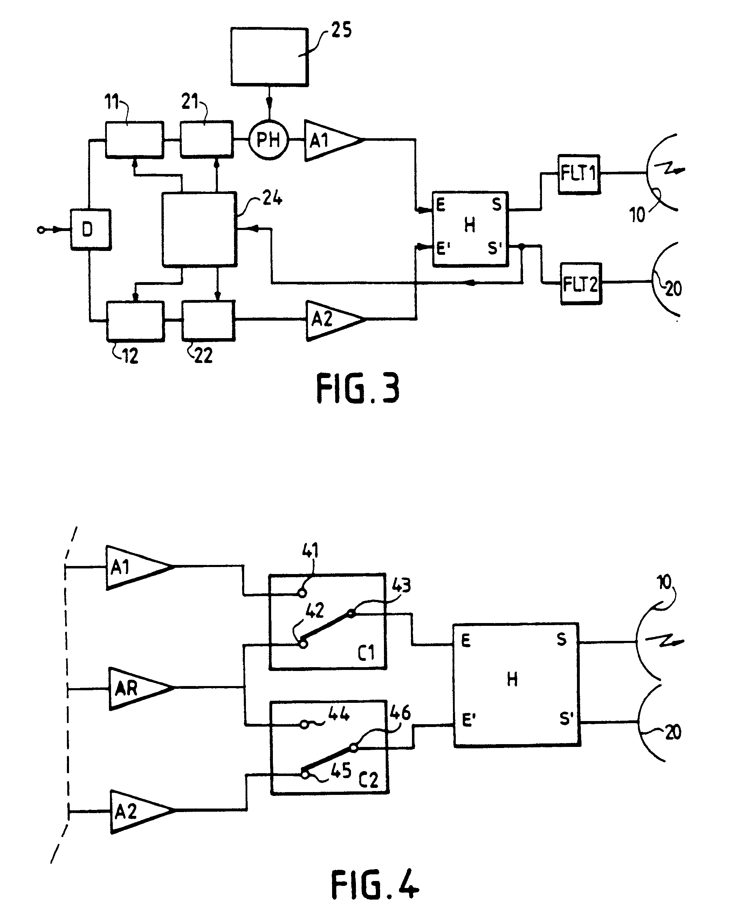

Dans de nombreux cas, les antennes 10,20 rayonnent respectivement des signaux à des fréquences différentes F1,F2 et fonctionnent successivement. On peut placer respectivement des filtres de bande FLT1, FLT2 entre les sorties S, S' du coupleur H et les antennes 10,20. Le filtre FLT1 ne laissera passer que les signaux à la fréquence F1 et le filtre FLT2 que les signaux à la fréquence F2. Cette variante est représentée sur la figure 3.

Cette figure 3 montre aussi un dispositif permettant de remédier éventuellement et automatiquement aux différences possibles dans les deux chaînes d'amplification.

On utilise pour cela d'une part un dispositif d'égalisation des longueurs électriques entre les sorties du diviseur D et les sorties S,S' du coupleur H et d'autre part un dispositif d'égalisation des amplitudes des signaux E et E' en entrée du coupleur H.

Pour égaliser les longueurs électriques, on peut placer respectivement à l'entrée de chaque amplificateur A1,A2 un déphaseur variable 11,12.

Pour égaliser les niveaux de puissance, on peut placer respectivement à l'entrée de chaque amplificateur A1,A2, en série avec les déphaseurs variables 11,12, un atténuateur variable 21,22.

On a représenté les déphaseurs variables 11,12 et les atténuateurs variables 21,22 entre le diviseur D et le (ou les) déphaseur variable PH mais on aurait pu les insérer entre le (ou les) déphaseur variable et l'entrée des amplificateurs A1, A2.

Les déphaseurs variables 11,12 d'une part et les atténuateurs variables 21,22 sont commandés différentiellement par un circuit d'asservissement classique 24 lui-même commandé par au moins un des signaux de sortie S' ou S.

On pourrait aussi envisager d'utiliser un dispositif de programmation 25 pour commander le déphaseur variable PH.

Un circuit de commutation selon l'invention présente de nombreux avantages par rapport aux circuits de l'art antérieur utilisant des commutateurs de puissance.

On se réfère à la figure 2.

Chaque amplificateur A1,A2 doit fournir environ une puissance P/2 pour que la puissance rayonnée par une des antennes 10 ou 20 soit P.

Dans le circuit de l'art antérieur, représenté à la figure 1, l'amplificateur A devait fournir une puissance environ de 1,25 P pour que P soit rayonnée par une des antennes 1 ou 2.

Les deux amplificateurs A1 et A2 sont 2,5 à 3 fois moins puissants que l'amplificateur A, leur fiabilité est augmentée. La fiabilité du circuit de commutation est aussi augmentée.

Le coût de deux amplificateurs de moyenne puissance est, en général, inférieur à celui d'un seul amplificateur de forte puissance.

La commutation est réalisée par une variation de phase de signaux à bas niveau de puissance. La fiabilité de la commutation est augmentée par rapport aux circuits classiques à commutateurs, où la commutation se fait sur des circuits à haut niveau de puissance.

Le fait d'utiliser deux chaînes d'amplification en parallèle permet de bénéficier des avantages bien connus de la mise en parallèle d'amplificateurs. Le facteur de bruit du circuit est égal à celui de l'un des amplificateurs et ce facteur est d'autant plus faible que la puissance de sortie des amplificateurs est faible. Le niveau d'harmoniques est réduit, le rapport d'ondes stationnaires (R.O.S) est amélioré.

Un circuit de commutation selon l'invention peut continuer si l'un des amplificateurs est en panne.

On se réfère à la figure 3. On suppose que l'amplificateur A1 est défaillant et que l'on désire alimenter l'antenne 10 avec un signal à la fréquence F1. Soit P/2 la puissance présente en sortie de l'amplificateur A2. L'entrée E du coupleur H ne reçoit rien. L'entrée E' du coupleur H reçoit la puissance P/2.

Chaque sortie S, S' fournit un signal, à la fréquence F1 dont la puissance est P/4. Le filtre FLT2 ne laisse pas passer le signal issu de S' puisqu'il est à la fréquence F1. Le signal issu de S' est réfléchi par le filtre FLT2 vers S'. Cette puissance P/4 se divise en deux parties égales entre les entrées E et E' de H. Si l'on fait le bilan, on s'aperçoit qu'un signal de puissance P/4 alimente l'antenne 10. Ce niveau de puissance permet d'assurer la mission pendant le temps où le bilan de liaison reste acceptable pour le système. Dans un bilan de liaison, on tient compte des pires conditions de propagation. Avec un niveau de puissance, la mission est assurée à N % du temps, (par exemple 99,9 %). Avec un niveau de puissance inférieur de 6 dB elle sera encore assurée à N'% du temps (par exemple 95 %).

La puissance P/4 revenant du filtre FLT2 vers S', une puissance P/8 revient par les entrées E et E' et doit se dissiper dans les amplificateurs A1,A2. Ce niveau de puissance est généralement acceptable et ne risque pas de détériorer l'amplificateur actif A2, si celui-ci, comme A1, est correctement conçu.

Dans le cas où les signaux qui alimentent successivement les antennes 10,20 sont à la même fréquence, on préféra utiliser un amplificateur redondant. On se réfère à la figure 4. L'amplificateur redondant porte la référence AR. On n'a pas représenté la partie du circuit de commutation placée en amont des amplificateurs A1,A2,AR. La sortie de l'amplificateur AR peut être commutée, grâce à deux commutateurs C1,C2, soit sur l'entrée E du coupleur H si l'amplificateur A1 est défaillant, soit sur l'entrée E' du coupleur H si l'amplificateur A2 est défaillant. Si les amplificateurs A1 et A2 fonctionnent normalement, l'amplificateur AR est passif.

Le commutateur C1 comporte deux entrées 41,42 et une sortie 43. L'entrée 41 est connectée à la sortie de A1, l'entrée 42 est connectée à la sortie de AR. La sortie 43 est connectée à l'entrée E du coupleur H.

Le commutateur C2 comporte deux entrées 44,45 et une sortie 46. L'entrée 44 est aussi connectée à la sortie de AR, l'entrée 45 est connectée à la sortie de A2. La sortie 46 est connectée à l'entrée E' du coupleur H.

On suppose que l'amplificateur A1 est défaillant. On désire alimenter l'antenne 10. Le commutateur C1 commute le signal présent sur son entrée 42 vers la sortie 43. Le signal de sortie de l'amplificateur AR est présent, aux pertes près, sur l'entrée E du coupleur H. Le commutateur C2 commute le signal présent sur son entrée 45 vers sa sortie 46. Le signal de sortie de l'amplificateur A2 est présent, aux pertes près, sur l'entrée E' du coupleur H. Pour que l'antenne 10 soit alimentée, il faut que les signaux en E et en E' soient en phase.

Dans cette configuration avec redondance, chaque amplificateur fournit une puissance moitiée de celle fournie par chacun des amplificateurs utilisés dans les circuits classiques avec deux chaines d'amplification identiques. Les deux commutateurs fonctionnent avec une puissance plus faible, leur fiabilité est accrue.

Au point de vue coût le prix de trois amplificateurs de puissance moyenne est généralement inférieur au prix de deux amplificateurs de forte puissance.

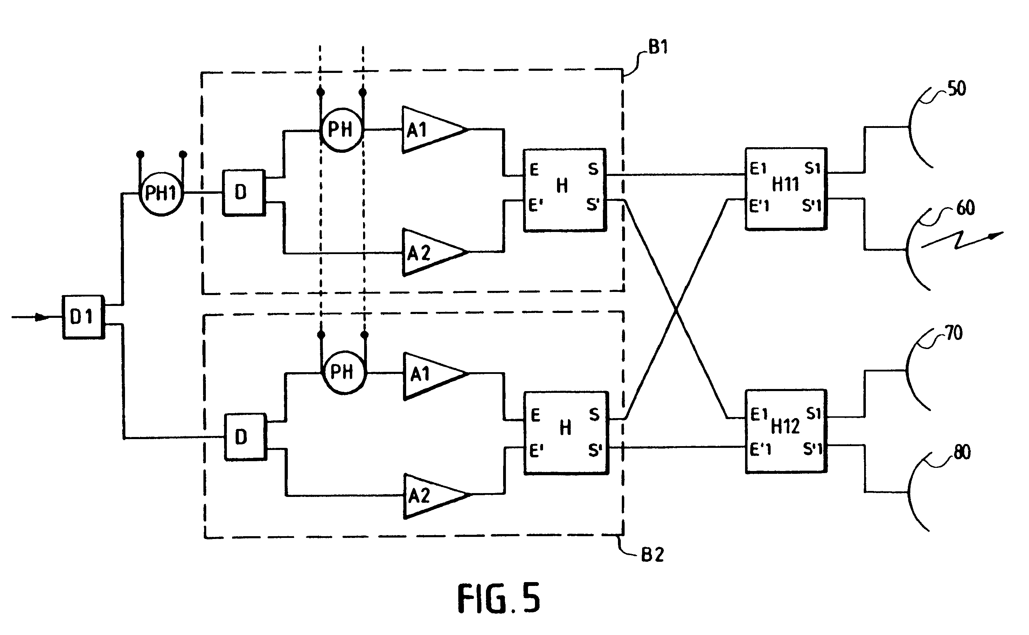

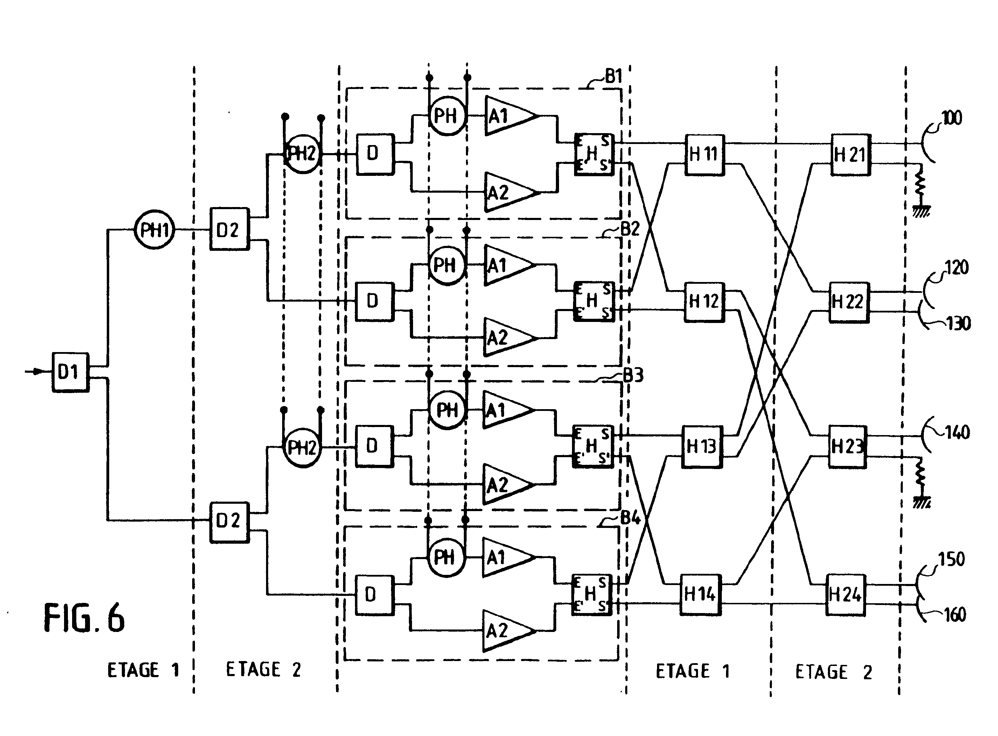

On peut être amené à commuter un signal sur une sortie choisie parmi $2^{n+1}$ (n entier supérieur ou égal à un). On utilisera alors un dispositif de commutation comprenant $m = 2^n$ circuits de commutation B1,... Bm conformes à l'invention. La figure 5 représente un tel dispositif avec n = 1 et la figure 6 un autre dispositif avec n = 2.

Dans la pratique n prendra la valeur 1 et l'on utilisera quatre sorties.

Les entrées des $2^n$ circuits de commutation B1, ... Bm sont alimentées par les sorties d'une cascade à n étages de diviseurs D1, ... Dn et moyens de déphasage commandables PH1, PH2,... PHn.

Les sorties S, S' des $2^n$ circuits de commutation B1,... Bm sont reliées aux entrées E1, E'1 d'une cascade à n étages de coupleurs H11... H1m, H21... H2m, Hn1... Hnm. Il y a m coupleurs par étage.

Chaque étage de rang i de diviseurs et moyens de déphasage comprend $2^{i-1}$ diviseurs Di et $2^{i-1}$ moyens de déphasage PHi commandables tous simultanément pour l'étage i. Ces $2^{i-1}$ moyens de déphasage PHi établissent en sortie de chaque diviseur et moyens de déphasage, des signaux soit en phase soit en opposition de phase. Ces signaux sont appliqués aux entrées des diviseurs Di + 1 de l'étage de rang i + 1.

L'entrée Ei d'un coupleur Hij est reliée à une des sorties Si-1 ou S'i-1 d'un coupleur Hi-1,k de l'étage de rang i-1. L'entrée E'i du même coupleur Hij est reliée à une des sorties Si-1, S'i-1 d'un autre coupleur Hi-1,l avec l différent de k. Les coupleurs Hi-1,k, Hi-1,l appartiennent à l'étage de rang i-1, le coupleur Hij à l'étage de rang i.

L'entrée du dispositif de commutation se fait à l'entrée du diviseur D1. On lui injecte un signal d'entrée avant amplification.

Les $2^{n+1}$ sorties du dispositif sont situées au niveau des sorties Sn et S'n des coupleurs Hn1, ... Hnm de l'étage de rang n. On pourra leur connecter au plus $2^{n+1}$ dispositifs d'utilisation. Sur la figure 5, on a représenté quatre antennes 50,60,70,80 connectées sur les sorties S1 et S'1 des coupleurs H11, H12. Si l'on utilise moins de $2^{n+1}$ dispositifs d'utilisation, les sorties Sn ou S'n non reliées à un dispositif d'utilisation seront connectées à une charge adaptée.

Sur la figure 6, on a représenté respectivement une antenne 100, 140 sur une des sorties du coupleur H21, H23 et une charge adaptée sur l'autre sortie. On a représenté respectivement deux antennes 120,130,150,160 en sortie des coupleurs H22 et H24.

Sur les figures 5 et 6, chaque moyen de déphasage PH1, PH2,...PHn a été représenté par un déphaseur variable commandable.

Chaque déphaseur d'un étage de rang i est connecté respectivement entre une sortie d'un déphaseur Di et l'entrée d'un déphaseur Di+1 de l'étage suivant. Ce n'est qu'un exemple. On aurait pu utiliser deux déphaseurs placés chacun sur une sortie de chaque diviseur. Les déphaseurs variables d'un même étage sont commandables simultanément. Les déphaseurs PH des $2^n$ circuits de commutation B1,..Bm sont aussi commandables simultanément.

Les déphaseurs PHn de l'étage de rang n sont connectés à l'entrée des circuits de commutation B1,..Bm.

On va étudier plus en détail le fonctionnement du dispositif de la figure 5. L'entrée E1 du coupleur H11 est reliée à la sortie S du coupleur H du circuit B1. L'entrée E'1 du coupleur H11 est reliée à la sortie S du coupleur H du circuit B2.

L'entrée E1 du coupleur H12 est reliée à la sortie S' du coupleur H du circuit B1. L'entrée E'1 du coupleur H12 est reliée à la sortie S' du coupleur H du circuit B2. On suppose que seule l'antenne 60 rayonne de la puissance. Elle est alimentée par le signal S'1 du coupleur H11. Les signaux E1 et E'1 en entrée du coupleur H11 sont en opposition de phase.

Le déphaseur PH1 est commandé pour que les signaux présents à l'entrée du circuit B1 et du circuit B2 soient en opposition de phase.

Au niveau des coupleurs H, on retrouve un signal sur la sortie S et sensiblement rien sur la sortie S'. Cela signifie que les déphaseurs variables PH sont commandés simultanément pour que les signaux injectés dans le coupleur H soient en phase.

Pour commuter le signal sur une autre antenne il suffit de commander différemment les déphaseurs PH et/ou le déphaseur PH1.

Les exemples décrits ne sont pas limitatifs de l'invention notamment en ce qui concerne la réalisation des amplificateurs, des dispositifs d'égalisation, des dispositifs d'utilisation.

## Revendications

1 - Circuit de commutation d'un signal de sortie vers une première ou une deuxième sortie comportant un coupleur (H) avec deux entrées (E,E') et deux sorties (S,S') qui réalisent les sorties du circuit de commutation, caractérisé en ce que deux amplificateurs (A1,A2) reçoivent en entrée, deux parties sensiblement égales en puissance d'un signal d'entrée à amplifier et alimentent chacun une entrée du coupleur (H) et en ce que des moyens de déphasage (PH) commandables, disposés en amont d'au moins un des amplificateurs, mettent en phase ou en opposition de phase les signaux présents en entrée du coupleur (H) afin d'obtenir le signal de sortie tantôt sur une des sorties du coupleur (H) tantôt sur l'autre.

2 - Circuit de commutation selon la revendication 1 caractérisé en ce qu'un coupleur diviseur (D) est alimenté par le signal d'entrée et fournit, sur deux sorties, les parties sensiblement égales en puissance du signal d'entrée.

3 - Circuit de commutation selon l'une des revendications 1 ou 2 caractérisé en ce que les deux amplificateurs (A1,A2) sont sensiblement identiques.

4 - Circuit de commutation selon l'une des revendications 1 à 3 caractérisé en ce que le coupleur (H) est un coupleur dit "180°".

5 - Circuit de commutation selon l'une des revendications 2 à 4 caractérisé en ce que les moyens de déphasage commandables sont réalisés par au moins un déphaseur variable commandable inséré entre une sortie du coupleur diviseur (D) et l'entrée de l'amplificateur (A1,A2) correspondant.

6 - Circuit de commutation selon l'une des revendications 1 à 5, caractérisé en ce qu'un dispositif d'égalisation (11,12) des longueurs électriques entre l'entée et la sortie des amplificateurs (A1,A2) et/ou un dispositif d'égalisation (21,22) des amplitudes des signaux de sortie des amplificateurs (A1, A2) est/sont disposés en entrée des amplificateurs.

7 - Circuit de commutation selon la revendication 6 caractérisé en ce qu'il est prévu un circuit d'asservissement (24) recevant au moins un signal de sortie du coupleur (H) pour commander les dispositifs d'égalisation (11,12), (21,22).

8 - Circuit de commutation selon l'une des revendications 1 à 7 caractérisé en ce qu'un dispositif d'utilisation (10,20) est connecté à chaque sortie (S,S') du circuit de commutation.

**9** - Circuit de commutation selon la revendication 8 caractérisé en ce qu'un filtre de bande (FLT1, FLT2) est inséré entre chaque sortie (S,S') du circuit de commutation et chaque dispositif d'utilisation (10,20), les filtres de bande (FLT1, FLT2) étant centrés sur des fréquences différentes.

**10** - Dispositif de commutation d'un signal vers une sortie prise parmi $2^{n+1}$ caractérisé en ce qu'il comporte $2^n$ circuits de commutation B1,B2,... selon l'une des revendications 2 à 7, les déphaseurs PH des $2^n$ circuits de commutation B1,B2... étant commandés simultanément, et en ce que :

- les entrées des $2^n$ circuits de commutation (B1, B2...) sont alimentées par les sorties d'une cascade de n étages de coupleurs diviseurs (D1, ... Dn) et moyens de déphasage (PH1,...,PHn) commandables,
- les sorties (S,S') des $2^n$ circuits de commutation (B1, B2...) sont reliées aux entrées d'une cascade de n étages de $2^{n+1}$ coupleurs (H11, H12,...Hnm) avec m = $2^n$ coupleurs dans chaque étage, le signal de sortie étant obtenu sur une des sorties des coupleurs de l'étage de rang n,
- chaque étage de rang i de coupleurs diviseurs (Di) et moyens de déphasage (PHi) comprend $2^{i-1}$ coupleurs diviseurs et $2^{i-1}$ moyens de déphasage commandables tous simultanément pour l'étage considéré, pour établir en sortie de chaque coupleur diviseur/moyens de déphasage, des signaux soit en phase, soit en opposition de phase, destinés à être appliqués aux entrées des coupleurs diviseurs Di+1 de l'étage de rang i+1
- les entrées des coupleurs (Hi1,... Him) d'un étage de rang i étant reliées chacune à une sortie d'un coupleur différent de l'étage précédent.

**11** - Dispositif de commutation selon la revendication 10 caractérisé en ce qu'au plus $2^{n+1}$ circuits utilisateurs (50,60,70,80) sont connectés aux sorties des $2^n$ coupleurs (H1n,... Hnm) de l'étage de rang n.

**12** - Dispositif de commutation selon la revendication 11 caractérisé en ce qu'une charge adaptée est connectée aux sorties des $2^n$ coupleurs (H1n,...Hnm) de l'étage de rang n non reliées à un circuit utilisateur.

FIG.1

FIG.2

FIG.3

FIG.4

FIG. 5

EP 0 442 797 A1

FIG. 6

ETAGE 2  ETAGE 1  ETAGE 2  ETAGE 1

H 21  H 22  H 23  H 24

H 11  H 12  H 13  H 14

B1  B2  B3  B4

A1  A2

PH

D

PH2

D2

PH1

D1

## EP 0 442 797 A1

Office européen
des brevets

**RAPPORT DE RECHERCHE EUROPEENNE**

Numero de la demande

EP  91 40 0337

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | US-A-4701716 (POOLE)<br>* colonne 2, ligne 37 - colonne 4, ligne 16; figures 1, 2 * | 1-3, 5-7 | H01P1/10<br>H03F3/60 |
| A | | 10-12 | |
| | --- | | |
| A | US-A-4010426 (RAMBO)<br>* colonne 2, lignes 6 - 22; figure 1 * | 1-3, 4 | |
| | --- | | |
| A | TELECOMMUNICATIONS AND RADIO ENGINEERING.<br>vol. 37/38, no. 1, janvier 1983, WASHINGTON US<br>pages 51 - 54; V.M.ANTONENKO ET AL.:<br>"A high-power stripline adder and switch"<br>* page 51, lignes 1 - 4; figure 1 * | 1, 2, 5, 11, 12 | |
| | --- | | |
| A | US-A-3419821 (JONES)<br>* le document en entier * | 1, 2, 5, 8, 10, 11 | |
| | --- | | |
| A | US-A-3058071 (WALSH ET AL.)<br>* colonne 2, ligne 18 - colonne 5, ligne 3; figure 1 * | 1, 2, 3, 5, 11, 12 | |
| | ----- | | DOMAINES TECHNIQUES RECHERCHES (Int. Cl.5 )<br><br>H01P<br>H03F |

Le présent rapport a été établi pour toutes les revendications

| Lieu de la recherche | Date d'achèvement de la recherche | Examinateur |
|---|---|---|
| LA HAYE | 16 MAI 1991 | DEN OTTER A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)